# EUROPEAN PATENT SPECIFICATION

(11) **EP 2 006 908 B1**
(45) Date of publication and mention of the grant of the patent: **14.08.2013**
(21) Application number: 08158703.2
(22) Date of filing: 20.06.2008
(51) Int. Cl.: H01L 23/31, H01L 21/60

(54) **Electronic device and method of manufacturing the same**
Elektronische Vorrichtung und dessen Herstellungsverfahren
Dispositif électronique et son procédé de fabrication

(30) Priority: 21.06.2007 JP 2007163763
(43) Date of publication of application: 24.12.2008
(73) Proprietor: Shinko Electric Industries Co., Ltd., Nagano-shi, Nagano 381-2287 (JP)
(72) Inventor: Yamano, Takaharu, Shinko Electric Industries Co., Ltd., Nagano-shi, Nagano 381-2287 (JP)
(74) Representative: Zimmermann & Partner

(56) References cited:
- JP-A- 2002 313 985
- US-A1- 2002 064 935
- US-A1- 2002 175 409
- US-A1- 2003 089 969
- US-A1- 2004 169 287
- US-A1- 2004 195 687

## Description

The present disclosure relates to an electronic device and a method of manufacturing the same and, more particularly, to an electronic device having bumps serving as external connection terminals, e.g. on a conductive pattern formed on an insulating layer, and a method of manufacturing the same.

There have been proposed various electronic devices in which electrodes, conductive patterns are formed on the substrate main body such as the semiconductor substrate. As one type of the electronic devices, there is the semiconductor device called "chip size package".

This chip size package has such a structure that the rewirings (the conductive layers) are formed on a device forming surface of a semiconductor chip, which is formed by dicing a wafer serving as a semiconductor substrate, via an insulating layer (passivation layer).

In manufacturing this chip size package, firstly a plurality of electrodes are formed on a semiconductor chip area of a semiconductor wafer, and then bumps are formed on respective electrodes by the wire bonding technology, for example. The bump is formed of the bonding wire by using the bonding machine.

Also, an insulating layer for protecting a circuit surface formed on the wafer is formed on the semiconductor wafer on which the bumps are formed. At this time, top end portions of the bumps are formed to expose from the insulating layer.

Then, the rewirings are formed over the insulating layer by the plating method, the printing method, or the like, for example. Then, the solder bumps serving as the external connection terminals are bonded to the rewirings, and then the wafer is cut into individual pieces by the dicing. Thus, the chip size package is manufactured (see e.g., JP-A-2002-313985).

US2002175409 describes a semiconductor device comprising an insulation layer formed on surfaces of semiconductor chips where the electrodes are formed, and a wiring layer formed on the insulation layer. The wiring layer formed on the insulation layer and the electrodes of the semiconductor chips are electrically connected to each other via connection members, such as wire bumps, etc. formed on the electrodes of the semiconductor chip.

US2003089969 describes a semiconductor device capable of relieving thermal stress without breaking wire. It comprises a semiconductor chip, a solder ball for external connection, wiring for electrically connecting the semiconductor chip and the solder ball, a stress relieving layer provided on the semiconductor chip, and a stress transmission portion for transmitting stress from the solder ball to the stress relieving layer in a peripheral position of an electrical connection portion of the solder ball and wiring.

US2004195687 describes a semiconductor apparatus in which flip chip bonding is enabled without any underfill, and which comprises a semiconductor device, an electrically insulating layer formed on the semiconductor device by mask-printing an electrically insulating material containing particles, and an external connection terminal formed on the electrically insulating layer and electrically connected with an electrode of the semiconductor device.

However, in the structure where the solder bumps serving as the external connection terminals are bonded to the rewirings formed on the insulating layer, when there is a difference in coefficient of thermal expansion between the semiconductor chip and the mounting substrate, a difference of thermal expansion due to the heating occurs between the semiconductor chip and the mounting substrate upon mounting the semiconductor device on the mounting substrate.

In the structure where the solder bumps are bonded directly to the rewirings, a stress generated due to this difference of thermal expansion is fully applied to the bonding position between the solder bump and the rewiring. For this reason, in mounting the semiconductor device on the mounting substrate, there is a problem that a part in the bonding position between the rewiring and the solder bump is broken. Accordingly, in the semiconductor device in the related art, there is a problem that mounting reliability is lowered.

Exemplary embodiments of the present invention address the above disadvantages and other disadvantages not described above. However, the present invention is not required to overcome the disadvantages described above, and thus, an exemplary embodiment of the present invention may not overcome any of the problems described above. According to aspects of the invention, a method of manufacturing an electronic device according to independent claim 1, and an electronic device according to independent claim 6 are provided. Further advantages, features, aspects and details of the invention are evident from the dependent claims, the description and the drawings.

It is an aspect of the present invention to provide a method of manufacturing an electronic device and an electronic device, capable of achieving an improvement of mounting reliability.

According to one or more aspects of the present invention, in a method of manufacturing an electronic device in which a plurality of first bumps serving as external connection terminals are formed on a conductive pattern, the method comprises:
(a) forming a second bump having a projection portion on an electrode pad formed on a substrate, the second bump being formed of a bonding wire;
(b) then forming an insulating layer on the substrate;
(c) exposing a portion of the projection portion from an upper surface of the insulating layer;
(d) forming a flat stress absorbing layer in a bump providing area, in which the first bumps are to be provided, on the insulating layer;
(e) forming a first conductive layer on the insulating layer and the stress absorbing layer and the exposed portion of the projection portion;
(f) forming a second conductive layer by an electroplating using the first conductive layer as a power feeding layer;
(g) forming the conductive pattern by patterning the second conductive layer; and
(h) forming the first bumps on the conductive pattern formed on the stress absorbing layer, whereby a stepped portion is formed on the conductive pattern in an outer peripheral position of the stress absorbing layer, and the conductive pattern is led onto the upper surface of the stress absorbing layer via this stepped portion.

According to one or more aspects of the present invention, the substrate may be a semiconductor substrate.

According to one or more aspects of the present invention, the stress absorbing layer may be formed of a resin having an elasticity.

According to one or more aspects of the present invention, the stress absorbing layer may be formed of the same material as the insulating layer.

According to one or more aspects of the present invention, in step (e), the first conductive layer may be formed by a vapor deposition method.

According to one or more aspects of the present invention, in step (a), the second bump may be formed of a bonding wire.

According to one or more aspects of the present invention, an electronic device comprises:
first bumps serving as external connection terminals;
a substrate on which an electrode pad are formed;
a second bump formed on the electrode pad, the second bump being formed of a bonding wire;
an insulating layer formed on the substrate; and
a conductive pattern formed on the insulating layer and coupled to the first bumps and the second bump; and
a stress absorbing layer provided in a bump providing area, in which the first bumps are provided, on the insulating layer and over which the first bumps are disposed. The conductive pattern (106) extends from a position of the insulating layer (105), in which the second bump (104) is exposed, to a predetermined position, in which the solder bumps (110) are formed on the bump providing area (135), so that a steeped portion is formed on the conductive pattern (106) at an outer peripheral position of the stress absorbing layer (120), and so that the conductive pattern (106) is led from the insulating layer (105) onto an upper surface of the stress absorbing layer (120) via the stepped portion.

According to one or more aspects of the present invention, the substrate may be a semiconductor chip.

Other aspects and advantages of the invention will be apparent from the following description, the drawings and the claims.

The above and other aspects, features and advantages of the present invention will be more apparent from the following more particular description thereof, presented in conjunction with the following drawings wherein:
FIG.1A is a sectional view showing a semiconductor device according to an embodiment of the present invention;
FIG.1B is a sectional view showing a bump and its neighborhood in FIG.1A in an enlarged manner;
FIG.2 is a sectional view showing a state that the semiconductor device according to an embodiment of the present invention is mounted on a mounting substrate;
FIG.3A is a sectional view (#1) showing a method of manufacturing the semiconductor device according to an embodiment of the present invention;
FIG.3B is a sectional view (#2) showing a method of manufacturing the semiconductor device according to an embodiment of the present invention;
FIG.3C is a sectional view (#3) showing a method of manufacturing the semiconductor device according to an embodiment of the present invention;
FIG.3D is a sectional view (#4) showing a method of manufacturing the semiconductor device according to an embodiment of the present invention;
FIG.3E is a sectional view (#5) showing a method of manufacturing the semiconductor device according to an embodiment of the present invention;
FIG.3F is a sectional view (#6) showing a method of manufacturing the semiconductor device according to an embodiment of the present invention;
FIG.3G is a sectional view (#7) showing a method of manufacturing the semiconductor device according to an embodiment of the present invention;
FIG.3H is a sectional view (#8) showing a method of manufacturing the semiconductor device according to an embodiment of the present invention;
FIG.3I is a sectional view (#9) showing a method of manufacturing the semiconductor device according to an embodiment of the present invention;
FIG.3J is a sectional view (#10) showing a method of manufacturing the semiconductor device according to an embodiment of the present invention;
FIG.3K is a sectional view (#11) showing a method of manufacturing the semiconductor device according to an embodiment of the present invention;
FIG.3L is a sectional view (#12) showing a method of manufacturing the semiconductor device according to an embodiment of the present invention;
FIG.3M is a sectional view (#13) showing a method of manufacturing the semiconductor device according to an embodiment of the present invention; and
FIG.4 is a sectional view showing a method of manufacturing a semiconductor device according to a variation of the embodiment of the present invention.

Exemplary embodiments of the present invention will be described with reference to the drawings hereinafter.

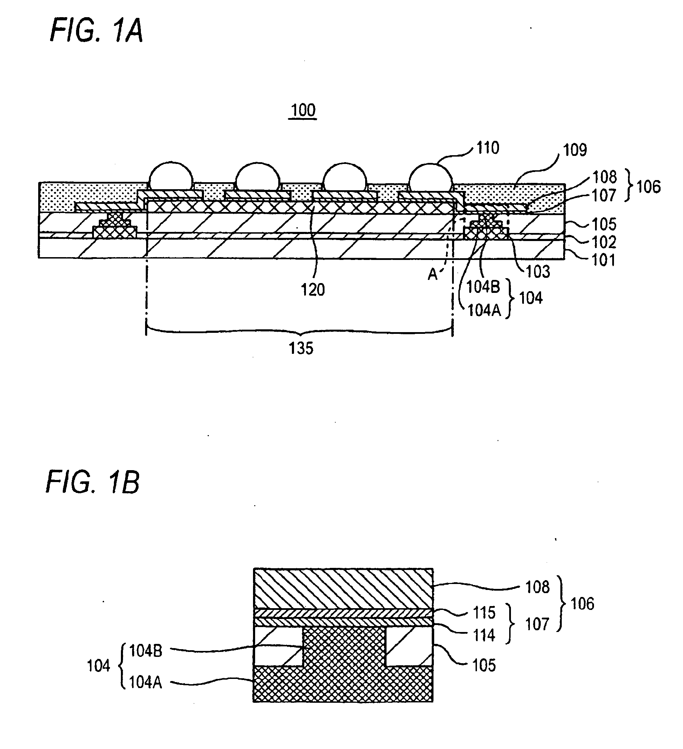

FIG.1A shows a semiconductor device according to an embodiment of the present invention. In the present embodiment, description will be made by taking a semiconductor device 100 (CSP) in a chip size as the electronic device as an example.

According to the semiconductor device 100 of the present embodiment, an insulating layer 105, a stress absorbing layer 120, and a conductive pattern 106 are formed on a passivation layer 102 of a semiconductor chip 101 on which electrode pads 103 are formed. Also, a bump 104 made of Au is formed on the electrode pad 103.

As shown in FIG.1B, the bump 104 consists of a bump main body 104A bonded to the electrode pad 103, and a projection portion 104B projecting from the bump main body 104A. This bump 104 is formed of the bonding wire made of Au, for example using the wire bonding machine. Concretely, the wire bonding machine performs successively bonding process of the bonding wire to the electrode pad 103 and cutting process of the bonding wire after bonding, and thus forms the bump 104 having the bump main body 104A and the projection portion 104B.

The conductive pattern 106 is sometimes called "rewiring", and the conductive pattern 106 is provided to differentiate (fan in) positions of the electrode pads 103 of the semiconductor chip 101 and positions of solder bumps 110 serving as the external connection terminals. Also, the insulating layer 105 is formed of an elastically deformable resin material to which a hardness adjusting material such as a filler called NCF, for example, is hardly added. This insulating layer 105 protects a circuit forming surface (a main surface) of the semiconductor chip 101, and constitutes the base material together with the stress absorbing layer 120 when the conductive pattern 106 is formed.

The conductive pattern 106 is constructed by forming a second conductive pattern 108 on a first conductive pattern 107. Also, as shown in FIG.1B in an enlarged fashion, the first conductive pattern 107 is constructed by forming a Cu film 115 on a Ti film 114.

The Ti film 114 and the Cu film 115 constituting the first conductive pattern 107 are formed by the sputtering method (the PVD method) as one type of the vapor deposition methods. Accordingly, the first conductive pattern 107 (the Ti film 114) is metallic-bonded to the bump 104 (the bump main body 104A), and thus improvement in the electrical and mechanical connectivity between the first conductive pattern 107 and the bump 104 can be achieved. The formation of the Ti film 114 and the Cu film 115 is not limited to the sputtering method. Other vapor deposition method (e.g., the CVD method) can be employed.

FIG.1B is a view showing an area, which is encircled with a broken line indicated by a symbol "A" in FIG.1A (the bump 104 and its neighborhood), of the above semiconductor device 100 in an enlarged manner.

When the first conductive pattern 107 is connected to the bumps 104 as described above, the conductive pattern 106 is connected to the electronic device of the semiconductor chip 101 via the bumps 104. Also, the solder bump 110 is formed in predetermined positions on the conductive pattern 106. Therefore, the solder bumps 110 are connected electrically to the semiconductor chip 101 via the conductive pattern 106.

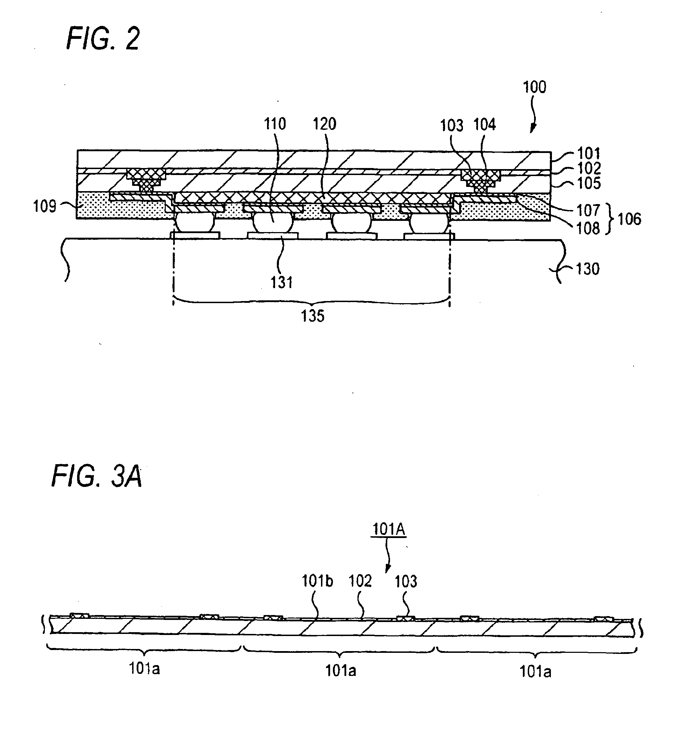

The solder bumps 110 serve as the external connection terminals. Hence, as shown in FIG.2, when the semiconductor device 100 is mounted on a mounting substrate 130, the solder bumps 110 are bonded to connection electrodes 131 formed on the mounting substrate 130. The solder bumps 110 are formed to project from opening portions that are formed in a solder resist layer (an insulating layer) 109. In this case, the solder resist layer 109 is formed to cover the insulating layer 105, the stress absorbing layer 120, and the conductive pattern 106.

Next, the stress absorbing layer 120 will be described hereunder.

The stress absorbing layer 120 is a flat member, and is formed on the insulating layer 105. Also, its forming area is set to coincide substantially with an area 135 in which the solder bumps 110 are provided (referred to as a "bump providing area" hereinafter). Therefore, a plurality of the solder bumps 110 are constructed such that all solder bumps are positioned over the stress absorbing layer 120.

In the present embodiment, the stress absorbing layer 120 is formed of the same material as the insulating layer 105. For this reason, the elastically deformable resin material to which a hardness adjusting material such as the filler called NCF, for example, is hardly added is employed. Also, a thickness of the stress absorbing layer 120 is set to the same thickness as that of the insulating layer 105 (e.g., 20 to 50 µm).

Also, in order to increase mounting reliability described later, it is preferable that coefficient of elasticity of the stress absorbing layer 120 should be set to extremely softly or conversely extremely rigidly. Concretely, it is preferable that a coefficient of elasticity of the stress absorbing layer 120 should be set to 20 to 1000 MPa when such layer is formed softly, and it is preferable that a coefficient of elasticity of the stress absorbing layer 120 should be set to 5000 MPa (5GPa) or more when such layer is formed rigidly. Here, a coefficient of line expansion of the semiconductor chip 101 (silicon) used in the present embodiment is 3.5 ppm, and a coefficient of line expansion of the mounting substrate 130 is 30 to 200 ppm. However, material, thickness, characteristics, etc. of the above constituent elements are not restricted to the above values.

Also, the projection portion 104B of the bump 104 is constructed such that the projection portion 104B is exposed in the area where only the insulating layer 105 is formed. Therefore, the conductive pattern 106 is extended from a position of the insulating layer 105, in which the projection portion 104B is exposed, to a predetermined position, in which the solder bumps 110 are formed on the bump providing area 135. As a result, a stepped portion is formed on the conductive pattern 106 in an outer peripheral position of the stress absorbing layer 120, and the conductive pattern 106 is led onto the upper surface of the stress absorbing layer 120 via this stepped portion.

As described above, according to the semiconductor device 100, the insulating layer 105 and the stress absorbing layer 120 are formed in the bump providing area 135 in which the solder bumps 110 are provided on the conductive pattern 106, and the insulating layer 105 and the stress absorbing layer 120 are formed of the elastically deformable resin material. Therefore, even when a stress is applied to the solder bumps 110, such stress can be absorbed by the insulating layer 105 and the stress absorbing layer 120.

Concretely, even though a stress generated due to a difference in thermal expansion between the semiconductor chip 101 and the mounting substrate 130 is applied to the solder bumps 110 when a heat is applied in boding the semiconductor device 100 shown in FIG.2 to the mounting substrate 130, this stress can be absorbed by the insulating layer 105 and the stress absorbing layer 120. Therefore, this stress is never applied to the bonding positions between the solder bumps 110 and the conductive pattern 106, so that it can be prevented that break occurs in the bonding positions between the solder bumps 110 and the conductive pattern 106. As a result, mounting reliability of the semiconductor device 100 onto the mounting substrate 130 can be improved by providing the stress absorbing layer 120.

Also, in the present embodiment, the stress absorbing layer 120 is not provided individually to positions opposing to the solder bumps 110 but formed widely to cover the bump providing area 135 in which a plurality of solder bumps 110 are provided. Therefore, even when a great stress that cannot be absorbed by such a structure that the stress absorbing layer is formed every solder bump 110 individually is applied to the particular solder bump 110, the stress absorbing layer 120 can be elastically deformed variously because such a layer is formed widely. As a result, such stress can be absorbed by the stress absorbing layer 120 without fail.

Consequently, mounting reliability of the semiconductor device 100 onto the mounting substrate 130 can also be improved by such a structure. In this case, the stress absorbing layer 120 is not always provided to the whole bump providing area 135, and the stress absorbing layer 120 can be provided partially to the areas where a stress occurs easily.

In the above embodiment, the insulating layer 105 and the stress absorbing layer 120 are formed of the same material, and the stress generated in the solder bumps 110 is also absorbed by the insulating layer 105 together with the stress absorbing layer 120. However, even when the insulating layer 105 is formed of an elastically nondeformable material, the stress applied to the solder bumps 110 can be absorbed by only the stress absorbing layer 120. Also, the stress absorbing layer 120 is not always formed of a single layer, and may be formed of a multilayer.

Next, a method of manufacturing the above semiconductor device 100 will be described with reference to FIG.3A to FIG.3M hereinafter. In this case, in FIG.3A to FIG.3M, the same reference symbols are affixed to the structures corresponding to the structures shown in FIG.1A to FIG.2, and their description will be omitted herein.

In order to manufacture the semiconductor device 100, in steps shown in FIG.3A, a semiconductor substrate 101A (a wafer, or the like, and referred simply to as a "substrate 101A" hereinafter) having a plurality of areas 101a, on which an electronic circuits are formed, (e.g., in grid-like fashion) is manufactured by the known method.

The above area 101a is an area corresponding to one semiconductor chip 101. The electrode pads 103 are formed on a device forming surface 101b of the area 101a on which the electronic device is formed. Also, a passivation layer 102 made of SiN(Si₃N₄), for example, is formed on portions of the device forming surface 101b except the electrode pads 103, whereby protection of the device forming surface 101b is attained.

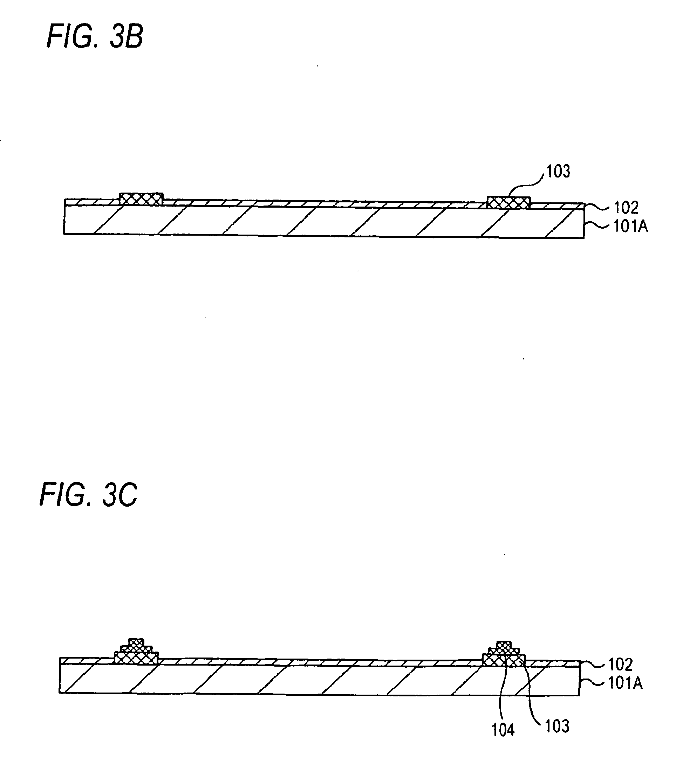

FIG.3B shows one area 101a of the substrate 101A shown in FIG.3A in an enlarged manner. In this case, for convenience of illustration and explanation, one area 101a is shown in FIG.3B to FIG.4 in an enlarged manner.

In steps shown in FIG.3C, the bump 104 is formed on the electrode pads 103 by the wire bonding machine, for example, respectively. This bump 104 is formed of the bonding wire that is made of Au. The wire bonding machine forms the bump main body 104A bonded to the electrode pad 103 and the projection portion 104B projecting from the bump main body 104A, by performing successively bonding process of the bonding wire to the electrode pad 103 and cutting process of the bonding wire after this bonding process.

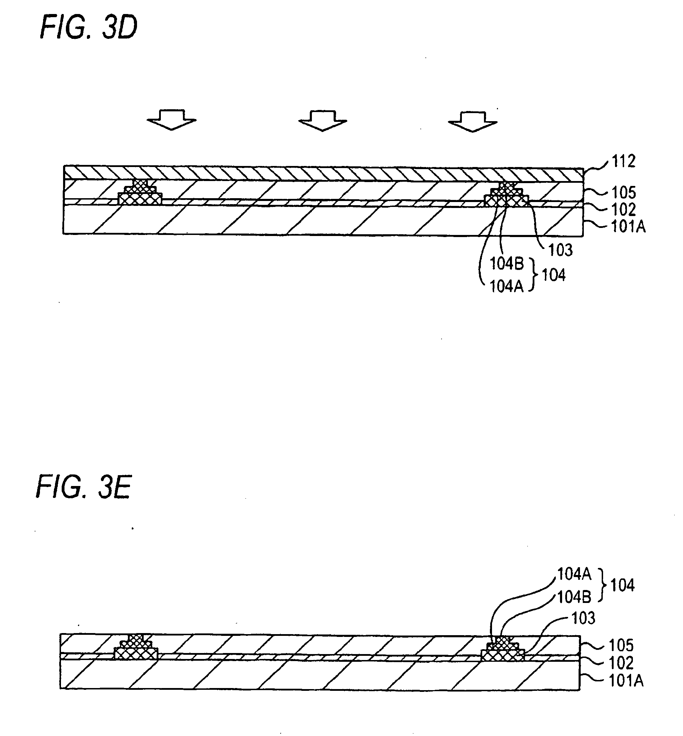

Then, in steps shown in FIG.3D, the insulating film 105 made of a resin material is laminated (pasted) on the whole surface of the substrate 101A (the passivation layer 102). As a material of the insulating layer 105, the elastically deformable soft resin material to which a hardness adjusting material such as a filler called NCF, for example, is hardly added is selected. Also, it is preferable that a thickness should be set to 20 to 50 µm.

The bumps 104 are embedded in the insulating layer 105 in a state that this insulating layer 105 is provided. However, there is no necessity that top ends of the projection portions 104B should necessarily be exposed from the upper surface of the insulating layer 105.

Then, a copper foil 112 is provided on the insulating layer 105, and a press-fitting process is applied. Accordingly, the insulating layer 105 is also pressed, and a part of the projection portions 104B of the bumps 104 is exposed from the upper surface of the insulating layer 105.

At this time, a thickness of the insulating layer 105 is selected such that the projection portions 104B are exposed from the upper surface of the insulating layer 105 in the press-fitting process without fail. Also, the projection portions 104B of the bumps 104 are pressed by the copper foil 112 in this press-fitting process, and a height of the top end portions are leveled.

In this case, the material of the insulating layer 105 is not limited to the above NCF, and various insulating material (resin materials) can be employed. For example, a build-up resin (an epoxy resin containing the filler) or a resin material called ACF can be employed as the insulating layer 105. Also, the layer formed on the insulating layer 105 is not always formed of the copper foil 112, and a temporary film made of PET can be employed. In addition, a single-sided copper-foil resin film in which a Cu foil is provided to one surface of a resin film can be employed.

After the press-fitting process, the copper foil 112 is removed by the etching method, for example. FIG.3E shows a state that the copper foil 112 is removed. As described above, the projection portions 104B are exposed from the insulating layer 105 at the press-fitting process and also their heights are leveled. Therefore, the projection portions 104B are exposed from the insulating layer 105 when the copper foil 112 is removed.

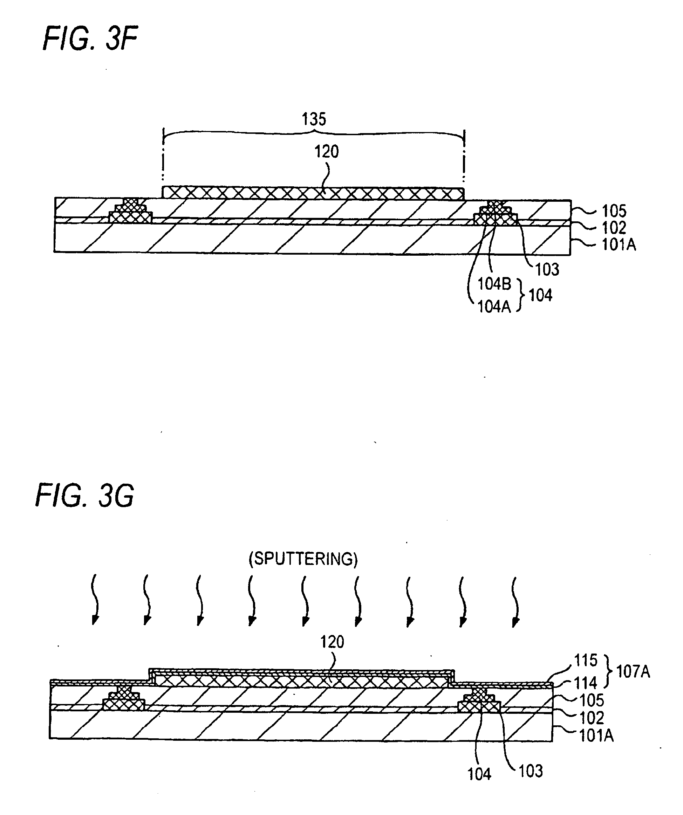

Then, in steps shown in FIG.3F, the stress absorbing layer 120 is laminated (pasted) on the insulating layer 105. The stress absorbing layer 120 is a flat sheet-like member, and is provided in the almost all surface of the bump providing area 135, in which the plurality of solder bumps 110 are provided in the later step, on the insulating layer 105.

In the present embodiment, the stress absorbing layer 120 is formed of the same material as the insulating layer 105. That is, the elastically deformable soft resin material to which a hardness adjusting material such as the filler called NCF, for example, is hardly added is employed as the stress absorbing layer 120. Also, a thickness of the stress absorbing layer 120 is equal to the insulating layer 105, and is set to 20 to 50 µm.

In this manner, when the material and the thickness of the stress absorbing layer 120 are set equal to those of the insulating layer 105, the same equipment used to form the insulating layer 105 can be employed as that used to form the stress absorbing layer 120. Therefore, the process of forming the stress absorbing layer 120 can be simplified, and also simplification of the manufacturing facilities can be attained.

Also, normally the solder bumps 110 serving as the external connection terminals are provided to fan-in from the provision position of the bumps 104. That is, the bump providing area 135 is positioned on the inner side than the forming positions of the bumps 104 on the semiconductor chip 101. Hence, the positions in which the projection portions 104B of the bumps 104 are exposed from the insulating layer 105 are positioned on the outside of the stress absorbing layer 120. Therefore, such a situation is never caused that the top end portions of the projection portions 104B are covered with the stress absorbing layer 120 by forming the stress absorbing layer 120.

In this case, the material of the stress absorbing layer 120 is not limited to the above NCF. Various materials (insulating materials) can be employed which have an elasticity that can absorb the stress generated between the solder bumps 110 and the conductive pattern 106. For example, a build-up resin (an epoxy resin containing the filler) or a resin material called ACF can be employed as the stress absorbing layer 120. Also, a thickness of the stress absorbing layer 120 is not necessarily set equal to that of the insulating layer 105, and the thickness can be adjusted appropriately to absorb the stress generated between the solder bumps 110 and the conductive pattern 106.

In this manner, when the stress absorbing layer 120 is formed on the insulating layer 105, a first conductive layer 107A is formed on the insulating layer 105, the stress absorbing layer 120, and the bump main bodies 104A in steps shown in FIG.3G. The first conductive layer 107A can be formed by the sputter method, which is one type of the vapor deposition method. In this case, the forming method is not limited to this method, and other vapor deposition method such as the CVD method can be employed.

The first conductive pattern 107 is constructed by forming the Cu film 115 on the Ti film 114. In order to form the first conductive pattern 107 on the insulating layer 105, firstly the Ti film 114 is formed by the sputtering with Ti as a target, and then the Cu film 115 is formed by the sputtering with Cu as a target. The processes of forming the Ti film 114 and the Cu film 115 can be performed successively while using the same sputtering equipment.

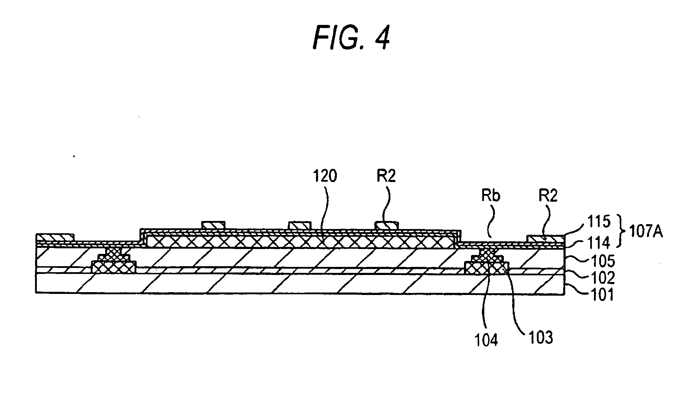

Also, in the present embodiment, a thickness of the Ti film 114 is set to 0.1 µm and a thickness of the Cu film 115 is set to 0.1 µm (In FIG.3G to FIG.3I and FIG.4, for convenience of illustration, the Ti film 114 and the Cu film 115 are depicted thicker than other layers in an exaggerated way). However, the thickness and the material of the Ti film 114 are not limited to the above. For example, an adhesive metal layer such as a Cr film whose thickness is set to 0.035 µm, or the like may be provided in place of the Ti film 114. Also, the formation of the Ti film 114 can be omitted, and only the Cu film 115 can be formed.

In the present embodiment, as described above, the first conductive layer 107A (the Ti film 114, the Cu film 115) is formed by using the sputter method. Therefore, the projection portions 104B projecting from the insulating layer 105 are metallic-bonded to the Ti film 114. Also, since the Cu film 115 formed on the Ti film 114 is formed by using the sputter method, the Cu film 115 is metallic-bonded to the Ti film 114.

Therefore, the bumps 104 and the first conductive layer 107A can be bonded tightly rather than the bonding method using the press-fitting or the conductive paste in the related art. Thus, the electrical and mechanical connectivity between them can be increased.

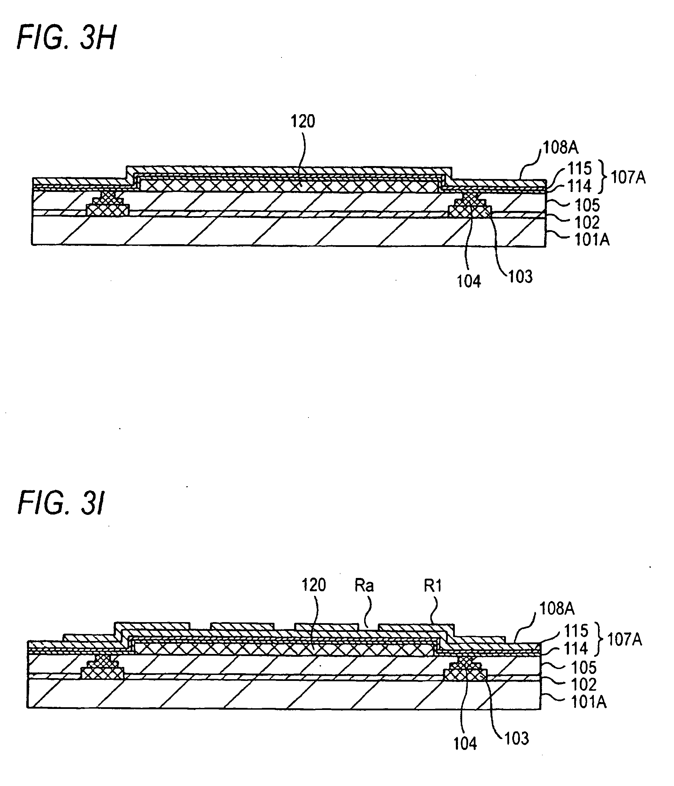

Then, in steps shown in FIG.3H to FIG.3J, the conductive pattern 106 connected to the bumps 104 is formed by the electroplating using the first conductive layer 107A as a power feeding layer (seed layer). As the method of forming the conductive pattern 106, for example, there are so-called subtractive method and semi-additive method. In the present embodiment, an example using the subtractive method will be described.

First, in steps shown in FIG.3H, a second conductive layer 108A made of Cu, for example, is formed on the first conductive layer 107A by the electroplating using the first conductive layer 107A (the Ti film 114, the Cu film 115) as a power feeding layer. Since the first conductive layer 107A is formed on the insulating layer 105 and the stress absorbing layer 120 formed on the insulating layer 105, the second conductive layer 108A is also formed on the whole upper surface of the insulating layer 105 and the stress absorbing layer 120.

Then, in steps shown in FIG.3I, a mask pattern R1 having opening portions Ra is formed on the second conductive layer 108A. The mask pattern R1 can be formed by forming a resist layer by a resist coating or a film pasting, and then patterning the resist layer through the photolithography method.

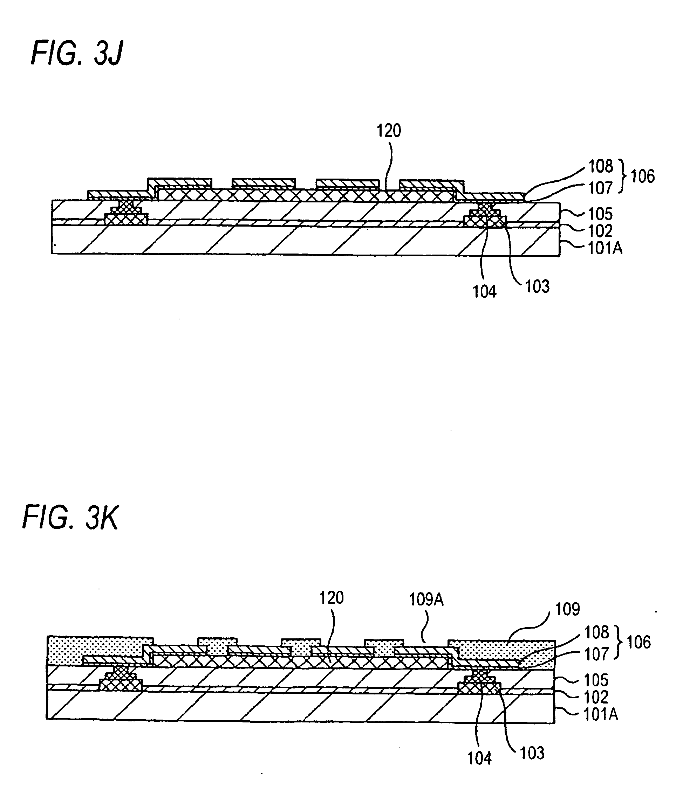

Then, the first conductive layer 107A and the second conductive layer 108A are etched while using the mask pattern R1 as a mask. Thus, as shown in FIG.3J, the conductive pattern 106 has the multilayer structure in which the first conductive pattern 107 and the second conductive pattern 108 are formed and is connected to the bumps 104. In the present embodiment, a thickness of the first conductive layer 107A is set to 1 to 2 µm and a thickness of the second conductive pattern 108 is set to about 10 to 30 µm. But these numerical value are given as an example, and the present invention is not limited to these numerical values.

Upon forming the conductive pattern 106, the electroplating method can be easily applied by using the first conductive layer 107A as a power feeding layer. For example, when the power feeding layer (seed layer) is formed by the electroless plating, a process of roughening the surface of the insulating layer (so-called desmear process) is needed and thus the process of forming the plating layer becomes complicated.

In contrast, according to the method of the present embodiment, the desmear process is not needed, and thus the power feeding layer (the first conductive layer 107A) can be formed easily by a simple method. Therefore, according to the above method, the method of manufacturing the semiconductor device can be made simple and a manufacturing cost can be reduced.

Then, in steps shown in FIG.3K, as necessary, the solder resist layer (insulating layer) 109 having opening portions 109A is formed on the insulating layer 105 after the process of roughening the surface of the conductive pattern 106 (Cu). A portion of the conductive pattern 106 is exposed from the opening portions 109A.

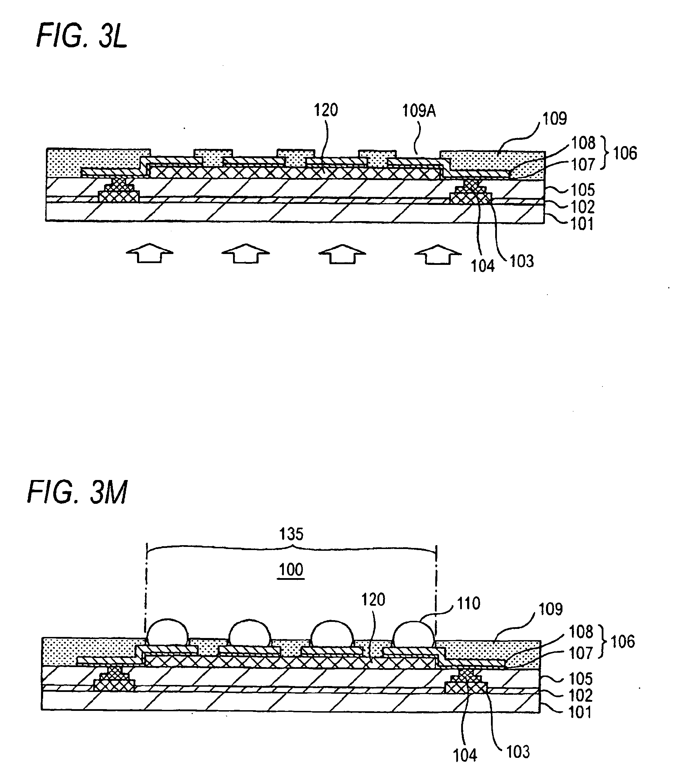

Then, in steps shown in FIG.3L, as necessary, the substrate 101A is thinned to a predetermined thickness by grinding the back surface of the substrate 101A.

Then, in steps shown in FIG.3M, the solder bumps 110 are formed on the conductive pattern 106 that is exposed from the opening portion 109A. The solder bumps 110 are formed in the bump providing area 135. Therefore, the insulating layer 105 and the stress absorbing layer 120 both being formed of elastically deformable material are interposed between the solder bumps 110 and the semiconductor chip 101. Then, the substrate 101A is cut into individual semiconductor chips by the dicing, whereby the semiconductor device 100 shown in FIG.1A is manufactured.

Meanwhile, in the above manufacturing method, the conductive pattern 106 is formed by the subtractive method. But the conductive pattern 106 may be formed by the semi-additive method. In this case, for example, after the steps shown in FIG.3A to FIG.3G are performed in the above manufacturing method, the following steps may be performed in place of steps in FIG.3H to FIG.3J.

That is, as shown in FIG.4, a mask pattern R2 having opening portions Rb corresponding to the forming positions of the conductive pattern 106 is formed on the first conductive layer 107A. The mask pattern R2 can be formed by forming a resist layer by a resist coating or a film pasting, and then patterning the resist layer through the photolithography method.

Then, the second conductive pattern is formed on the first conductive layer 107A, which is exposed from the opening portions Rb, by the electroplating using the first conductive layer 107A as a power feeding layer (a seed layer). Then, the mask pattern R2 is peeled off, and then the extra power feeding layer 107A exposed when the mask pattern R2 is peeled off is removed by etching. Thus, the conductive pattern 106 shown in FIG.3J can be formed.

While the present invention has been shown and described with reference to certain exemplary embodiments thereof, other implementations are within the scope of the claims.

Concretely, instead of the semiconductor substrate, the glass substrate or the multilayered wiring substrate can be employed as the substrate 101A. Accordingly, exemplary embodiments of the present invention are applicable to various electronic devices using these substrates.

Also, in the above embodiment, the stress absorbing layer 120 is formed as a single layer structure. The multilayered structure in which a plurality of layers each having the same or different characteristics (elasticity, etc.) are formed may be employed.

According to the present invention, the stress absorbing layer is formed in the bump providing area on the insulating layer, and also the first bumps are formed on the conductive pattern formed on this stress absorbing layer. Therefore, even when a difference of thermal expansion exists between the substrate and the mounting substrate on which the electronic device is mounted, a stress generated due to this difference of thermal expansion can be absorbed by the stress absorbing layer, and such a situation can be prevented that the stress is applied to the connection position between the first bumps and the wiring pattern. As a result, break never occurs in the bonding position between the first bumps and the wiring pattern, and thus mounting reliability can be improved.

This application is based on and claims priority from Japanese Patent Application No. 2007-163763, filed on June 21, 2007.

## Claims

1. A method of manufacturing an electronic device in which a plurality of first bumps (110) serving as external connection terminals are formed on a conductive pattern (106), the method comprising:
(a) forming a second bump (104) having a projection portion (104A) on an electrode pad (103) formed on a substrate (101), the second bump (104) being formed of a bonding wire;
(b) then forming an insulating layer (105) on the substrate (101);
(c) exposing a portion of the projection portion (104A) from an upper surface of the insulating layer (105);
(d) forming a flat stress absorbing layer (120) in a bump providing area (135), in which the first bumps (110) are to be provided, on the insulating layer;
(e) forming a first conductive layer (107) on the insulating layer (105) and the stress absorbing layer (120) and the exposed portion of the projection portion (104A);
(f) forming a second conductive layer (108) by an electroplating using the first conductive layer (107) as a power feeding layer;
(g) forming the conductive pattern (106) by patterning the second conductive layer (108); and
(h) forming the first bumps (110) on the conductive pattern (106) formed on the stress absorbing layer (120),
whereby a stepped portion is formed on the conductive pattern (106) in an outer peripheral position of the stress absorbing layer (120), and the conductive pattern (106) is led onto the upper surface of the stress absorbing layer (120) via this stepped portion.

2. The method according to claim 1, wherein the substrate (101) is a semiconductor substrate.

3. The method according to claim 1 or 2, wherein the stress absorbing layer (120) is formed of a resin having an elasticity.

4. The method according to any one of the preceding claims, wherein the stress absorbing layer (120) is formed of the same material as the insulating layer (105).

5. The method according to any one of the preceding claims, wherein in step (e),
the first conductive layer (107) is formed by a vapor deposition method.

6. An electronic device, comprising:
first bumps (110) serving as external connection terminals;
a substrate (101) on which an electrode pad (103) is formed;
a second bump (104) formed on the electrode pad (103), the second bump (104) being formed of a bonding wire;
an insulating layer (105) formed on the substrate; and
a conductive pattern (106) formed on the insulating layer (105) and coupled to the first bumps (110) and the second bump (104); and
a stress absorbing layer (120) provided in a bump providing area (135), in which the first bumps (110) are provided, on the insulating layer (105) and over which the first bumps (110) are disposed, wherein
the conductive pattern (106) extends from a position of the insulating layer (105), in which the second bump (104) is exposed, to a predetermined position, in which the solder bumps (110) are formed on the bump providing area (135), so that a stepped portion is formed on the conductive pattern (106) at an outer peripheral position of the stress absorbing layer (120), and so that the conductive pattern (106) is led from the insulating layer (105) onto an upper surface of the stress absorbing layer (120) via the stepped portion.

7. The electronic device according to claim 6, wherein the substrate (101) is a semiconductor chip.

## Patentansprüche

1. Verfahren zum Herstellen eines elektronischen Bauelements, bei dem mehrere erste Kontakthöcker (110), die als externe Verbindungsanschlüsse dienen, auf einer leitfähigen Struktur (106) ausgebildet sind, wobei das Verfahren Folgendes umfasst:
(a) Ausbilden eines zweiten Kontakthöckers (104), der einen Vorsprungabschnitt (104A) auf einer Elektrodeninsel (103) aufweist, die auf einem Substrat (101) ausgebildet ist, wobei der zweite Kontakthöcker (104) aus einem Bondungsdraht gebildet ist;
(b) anschließendes Ausbilden einer Isolierschicht (105) auf dem Substrat (101);
(c) Freilegen eines Abschnitts des Vorsprungabschnitts (104A), ausgehend von einer Oberseite der Isolierschicht (105);
(d) Ausbilden einer flachen, spannungsabbauenden Schicht (120) in einer Kontakthöckerbereitstellungsfläche (135), in der die ersten Kontakthöcker (110) ausgebildet werden sollen, auf der Isolierschicht;
(e) Ausbilden einer ersten leitfähigen Schicht (107) auf der Isolierschicht (105) und der spannungsabbauenden Schicht (120) und dem freigelegten Abschnitt des Vorsprungabschnitts (104A);
(f) Ausbilden einer zweiten leitfähigen Schicht (108) mittels eines Elektroplattierungsverfahrens unter Verwendung der ersten leitfähigen Schicht (107) als eine Stromzuführschicht;
(g) Ausbilden der leitfähigen Struktur (106) durch Strukturieren der zweiten leitfähigen Schicht (108); und
(h) Ausbilden der ersten Kontakthöcker (110) auf der leitfähigen Struktur (106), die auf der spannungsabbauenden Schicht (120) ausgebildet ist,
wobei ein gestufter Abschnitt auf der leitfähigen Struktur (106) an einer Außenumfangsposition der spannungsabbauenden Schicht (120) gebildet ist, und die leitfähige Struktur (106) über den gestuften Abschnitt auf eine Oberseite der spannungsabbauenden Schicht (120) geführt ist.

2. Verfahren nach Anspruch 1, wobei das Substrat (101) ein Halbleitersubstrat ist.

3. Verfahren nach Anspruch 1 oder 2, wobei die spannungsabbauende Schicht (120) aus einem elastischen Harz gebildet ist.

4. Verfahren nach einem der vorangehenden Ansprüche, wobei die spannungsabbauende Schicht (120) aus dem gleichen Material besteht wie die Isolierschicht (105).

5. Verfahren nach einem der vorangehenden Ansprüche, wobei in Schritt (e):
die erste leitfähige Schicht (107) durch ein Aufdampfungsverfahren gebildet wird.

6. Elektronisches Bauelement, das Folgendes umfasst:
erste Kontakthöcker (110), die als externe Verbindungsanschlüsse dienen;
ein Substrat (101), auf dem eine Elektrodeninsel (103) ausgebildet ist;
einen zweiten Kontakthöcker (104), der auf der Elektrodeninsel (103) ausgebildet ist, wobei der zweite Kontakthöcker (104) aus einem Bondungsdraht gebildet ist;
eine Isolierschicht (105), die auf dem Substrat ausgebildet ist; und
eine leitfähige Struktur (106), die auf der Isolierschicht (105) ausgebildet ist und mit dem ersten Kontakthöcker (110) und dem zweiten Kontakthöcker (104) gekoppelt ist; und
eine spannungsabbauende Schicht (120), die in einer Kontakthöckerbereitstellungsfläche (135), in der die ersten Kontakthöcker (110) angeordnet sind, auf der Isolierschicht (105) angeordnet ist und über der die ersten Kontakthöcker (110) angeordnet sind, wobei
sich die leitfähige Struktur (106) von einer Position der Isolierschicht (105), in der der zweite Kontakthöcker (104) frei liegt, zu einer vorgegebenen Position, in der die Lötkontakthöcker (110) auf der Kontakthöckerbereitstellungsfläche (135) ausgebildet sind, erstreckt, dergestalt, dass ein gestufter Abschnitt auf der leitfähigen Struktur (106) an einer Außenumfangsposition der spannungsabbauenden Schicht (120) gebildet wird, und dergestalt, dass die leitfähige Struktur (106) von der Isolierschicht (105) über den gestuften Abschnitt auf eine Oberseite der spannungsabbauenden Schicht (120) geführt wird.

7. Elektronisches Bauelement nach Anspruch 6, wobei das Substrat (101) ein Halbleiterchip ist.

## Revendications

1. Procédé de fabrication d'un dispositif électronique, dans lequel une pluralité de premières bosses (110) servant de bornes de connexion externes sont formées sur un modèle conducteur (106), le procédé comprenant:
(a) former une deuxième bosse (104) présentant une partie saillante (104A) sur un patin d'électrode (103) formé sur un substrat (101), la deuxième bosse (104) étant formée à partir d'un fil d'assemblage;
(b) puis, former une couche isolante (105) sur le substrat (101);
(c) exposer une portion de la partie en saillie (104A) depuis une surface supérieure de la couche isolante (105);
(d) former une couche d'absorption de sollicitation plane (120) dans une zone de création de bosses (135) dans laquelle doivent être créées les premières bosses (110) sur la couche isolante;
(e) former une première couche conductrice (107) sur la couche isolante (105) et la couche d'absorption de sollicitation (120) et la portion exposée de la partie en saillie (104A);
(f) former une deuxième couche conductrice (108) par un électro-placage à l'aide de la première couche conductrice (107) comme couche d'alimentation de courant;
(g) former le modèle conducteur (106) en modelant la deuxième couche conductrice (108); et
(h) former les premières bosses (110) sur le modèle conducteur (106) formé sur la couche d'absorption de sollicitation (120),
dans lequel une partie étagée est formée sur le modèle conducteur (106) en une position périphérique extérieure de la couche d'absorption de sollicitation (120), et le modèle conducteur (106) est conduit sur une surface supérieure de la couche d'absorption de sollicitation (120) via la partie étagée.

2. Procédé selon la revendication 1, dans lequel le substrat (101) est un substrat semi-conducteur.

3. Procédé selon la revendication 1 ou 2, dans lequel la couche d'absorption de sollicitation (120) est formée en une résine présentant une élasticité.

4. Procédé selon l'une quelconque des revendications précédentes, dans lequel la couche d'absorption de sollicitation (120) est formée du même matériau que la couche isolante (105).

5. Procédé selon l'une quelconque des revendications précédentes, dans lequel, à l'étape (e),
la première couche conductrice (107) est formée par un procédé de dépôt à la vapeur.

6. Dispositif électronique, comprenant:
des premières bosses (110) servant de bornes de connexion externes;
un substrat (101) sur lequel est formé un patin d'électrode (103);
une deuxième bosse (104) formée sur le patin d'électrode (103), la deuxième bosse (104) étant formée à partir d'un fil d'assemblage;
une couche isolante (105) formée sur le substrat; et
un modèle conducteur (106) formé sur la couche isolante (105) et couplé aux premières bosses (110) et à la deuxième bosse (104); et
une couche d'absorption de sollicitation (120) prévue dans une zone de création de bosses (135) dans laquelle sont créées les premières bosses (110) sur la couche isolante (105) et sur laquelle sont disposées les premières bosses (110), où
le modèle conducteur (106) s'étend d'une position de la couche isolante (105), dans laquelle la deuxième bosse (104) est exposée, à une position prédéterminée dans laquelle les bosses de soudure (110) sont formées sur la zone de création de bosses (135), de sorte que soit formée une partie étagée sur le modèle conducteur (106) en une position périphérique extérieure de la couche d'absorption de sollicitation (120), et de sorte que le modèle conducteur (106) soit conduit de la couche isolante (105) sur une surface supérieure de la couche d'absorption de sollicitation (120) via la partie étagée.

7. Dispositif électronique selon la revendication 7, dans lequel le substrat (101) est une puce à semi-conducteur.
